Europäisches Patentamt

European Patent Office

Office européen des brevets

(11) Publication number: **0 202 447**
**B1**

# EUROPEAN PATENT SPECIFICATION

(45) Date of publication of patent specification: **04.07.90**

(51) Int. Cl.⁵: **G 01 R 31/28**

(21) Application number: **86104774.4**

(22) Date of filing: **08.04.86**

(54) Printed circuit board function testing system.

(30) Priority: **19.04.85 JP 82237/85**

(43) Date of publication of application:
**26.11.86 Bulletin 86/48**

(45) Publication of the grant of the patent:
**04.07.90 Bulletin 90/27**

(84) Designated Contracting States:
**DE FR GB IT NL**

(56) References cited:
**EP-A-0 087 943**
**DE-A-1 900 298**

**IBM TECHNICAL DISCLOSURE BULLETIN, vol. 19, no. 8, January 1977, page 3182; A.H. NAY et al.: "Test system for logic cards"**

**IBM TECHNICAL DISCLOSURE BULLETIN, vol. 19, no. 3, August 1976, page 815; R. SUDING: "Low-cost mapping scanner"**

(73) Proprietor: **Graphtec Kabushiki Kaisha
3-19-6, Nishishinagawa Shinagawa-ku
Tokyo (JP)**

(72) Inventor: **Chiba, Takamasa c/o Kawasaki
Electronica Co.,Ltd.
1928 Nakanoshima Tama-ku
Kawasaki-shi Kanagawa (JP)**

(74) Representative: **Zeitler, Giselher
Postfach 26 02 51
D-8000 München 26 (DE)**

(56) References cited:
**IBM TECHNICAL DISCLOSURE BULLETIN, vol. 18, no. 5, October 1975, pages 1589-1592; P.L. GARDNER et al.: "Paper menus and keyboards for digitizing tablets"**

Courier Press, Leamington Spa, England.

## Description

### Field of the Invention

This invention relates to a PC (Printed Circuit) board function testing system that provides judgement of quality acceptance or rejection of a subject PC board carrying in operation by comparison with a set of base data obtained from a normally functioning PC board in a device in actual operation, more particularly, said comparison is made respectively between a plurality of corresponding test points of said subject PC board and said base PC board.

### Background of the Invention

These days, the PC board on which electronic elements are embedded is used in the wide range of the technical fields, such as in computers, in electrical applicances, and in air conditioners of various types. Quick and reliable function test of the mass produced PC board is of vital necessity.

In the prior art function tester (see for example IBM TECHNICAL DISCLOSURE BULLETIN, vol. 19, no. 8, January 1977, page 3182; A. H. NAY et al.: "Test system for logic cards", and DE—A—1 900 298), a plurality of circuit blocks are selected according to their predicted functions and their test points are determined. And then, the rated performance of current and voltage, its waveform, frequency and the like at said test points are analyzed and calculated based on the circuit design, and made into a program for the computer application. Preparation of the program requires a plurality of skilled engineers and a long period of working time. When the program is prepared, said subject PC board is connected through GP-IB (General Purpose Information Bus) to a dummy device so that actual operation is simulated under the command of the computer program. Meanwhile, a signal detecting device so arranged that all the test points of the back surface of said PC board are contacted by the equal number of probes, which resultantly makes said device bulky in size. Said probes are connected by way of the same number of relays to a heavy duty and expensive computer which stores the detected signals. Said subject data stored are then compared with said programmed data for quality acceptance judgement.

In the prior art, the base data and program preparations require not only a long period of time but skilled engineers, resulting in large expenses and possible delay in the manufacturing schedule. Another drawback of the prior art is that there are cases that the subject PC board whose quality has been accepted at the simulation test does not function accepted in an actual device. It necessitates not only reworking of itself but correction of the program, which results in further delay in the manufacturing schedule and additional expenses. The function tester of the prior art is very expensive as it requires a large capacity computer and a large sized probing device, and its use also is expensive because of the reason described above.

It is, accordingly, an object of this invention to provide a system wherein the base signal previously obtained from the PC board (base PC board) connected to the device in acutal operation, and a signal of the subject PC board connected to the active device in operation are compared in a CPU (Central Processing Unit) for judgement of quality acceptability of said subject PC board.

It is another object of this invention to provide means to obtain an analogue waveform signal by a signal probe, of which X-Y-Z movements are controlled by coordinate signals of the CPU storing a plurality of coordinate test points and a sequential order, and which contacts a test point of the base PC board and its corresponding test point of the subject PC board in said sequential order; X-Y coordinates of a plurality of said test points and the contacting sequential order having been stored in the CPU.

It is another object of this invention to provide means for waveform converting and memorizing, whereby both analogue signals obtained at said test points are monitored on CRT to process them to be easy-to-compare base and subject data comprising digital waveform signals.

It is a further object of this invention to provide a testing system, in which said CPU that stores and compares said base data and said subject data for judgement of the quality acceptance is commanded by key operation at a keyboard, in which test results are printed out showing in the number whether said subject data is within the range of the level set in advance provided by said base data and is stored in a floppy disk, and the resulted comparison at each test point is displayed on CRT in analogue waveform for visual evaluation.

### Summary of the Invention

In accordance with this invention, the function testing system and its use is provided to carry out the function test without the program to simulate the actual operation using the dummy, resulting in elimination of the work by the skilled engineers and requirement of no large capacity computer and bulky detecting device, thus lowering the cost of the system.

In brief, this invention contemplates a testing system for obtaining the aforementioned objects: A keyboard is connected to a small sized CPU (Central Processing Unit) such as a micro-computer, to which a CRT for displaying both the base data and the subject data for evaluation, a floppy disk drive and a printer are connected. Meanwhile, said CPU is connected with a coordinate detecting means which comprises a digitizer for memorizing and delivering coordinate signals for the test points. A bear-board or a test point indicating sheet, in which X-Y coordinates and tracking sequence members of the test points are shown, is placed in position in said coordinate detecting means in order to define the coordinates. Said CPU is also connected with a waveform detecting means, in which a probe is driven by the coordinate commanding signals from said CPU in X-Y-Z directions for detecting function. A base PC board or a subject PC board removed from a device in operation is set in said waveform detecting means while the PC board is connected with the device through an extension cable. Said waveform detecting means is connected to a wave for converting and memorizing means, to which said CPU is connected. Said waveform converting and memorizing means is for processing and converting said analogue signal to digital signal. Thus obtained digital signals of both the base data and the subject data are fed to said CPU and compared and evaluated, and then the results are displayed.

A testing system of this invention composed as described above is: coordinate signals are obtained from a plurality of test points by means of the coordinate detecting means, and the obtained signals are delivered from the CPU as drive commanding signals in order to drive a single probe of the wave for detecting means, which tracks the test points of the base PC board connected to the device in operation; thus analogue signals for the test points are obtained and are sent to the waveform converting and memorizing means in which they are processed and converted to digital signals, which are then stored in the CPU as the base data, the waveform converting and memorizing means being controlled by condition commanding signals. The coordinate signals of all addresses are processed and stored in the same manner. Signals at test points of the subject PC board are obtained in accordance with said coordinate commanding signal, processed and stored in the memory means of said CPU in the same manner as said base data. Said base data is converted to a test range data which is a dual level data, upper and lower levels between which is defined as quality acceptance range so that the signal from the subject PC board is checked if it comes within the range for quality acceptance.

An advantage of this invention is that the base data is taken after performance characteristics of a normally functioning PC board in a normally functioning device in operation instead of preparing a test program as is the case of the prior art which requires a plurality of skilled engineers and a long period of time.

The analogue waveform at a test point of the base PC board in actual operation is obtained by a single probe in the waveform pick-up means, of which tracking of the test points are controlled by said drive instruction signals; said analogue waveform signal fed to the waveform converting and memorizing means is processed by instruction of condition command signal to be digital signal which is stored in memory means of said CPU as the base data. The coordinate signal of all addresses are processed and stored in the same manner. Signals at test points of the subject PC board are picked up by control of said coordinate instruction signal, processed and stored in the memory means of said CPU in the same manner as said base data. Said base data is converted to a test range data which is a dual level data, upper and lower levels between which is defined as a quality acceptance range so that the signal from the subject PC board is checked if it comes within the range for quality acceptance.

Another advantage of this invention is that the expensive and bulky multi-probes are replaced by a single probe.

Another advantage of this invention is that said waveform converting and memorizing means does not require a large case as in the prior art which requires a plurality of skilled engineers and a long period of time.

Another advantage of this invention is that the expensive and bulky multi-probe device is replaced by a single probe device.

Another advantage of this invention is that said waveform converting and memorizing means does not require a large CPU, instead of which a compact and less expensive micro-computer is used, thus the total function testing system is constructed compact and less expensive.

Further advantage of this invention is that test results are correct and reliable for immediate use in the device as the actually functioning PC board connected to said device is a source of the test base data.

Brief Description of the Drawings

Fig. 1 shows a block diagram of the whole system of this invention.

Fig. 2 shows a block diagram of the waveform converting and memorizing means comprising a pre-conditioner and a transient memory.

Fig. 3 shows an example of a base data displayed on CRT and a waveform from a subject PC board.

Fig. 4 shows a flow chart of the procedures to process the base data at a test point.

Fig. 5 shows a flow chart of the procedures to process a data from the subject PC board at a test point.

Detailed Description of the Preferred Embodiment

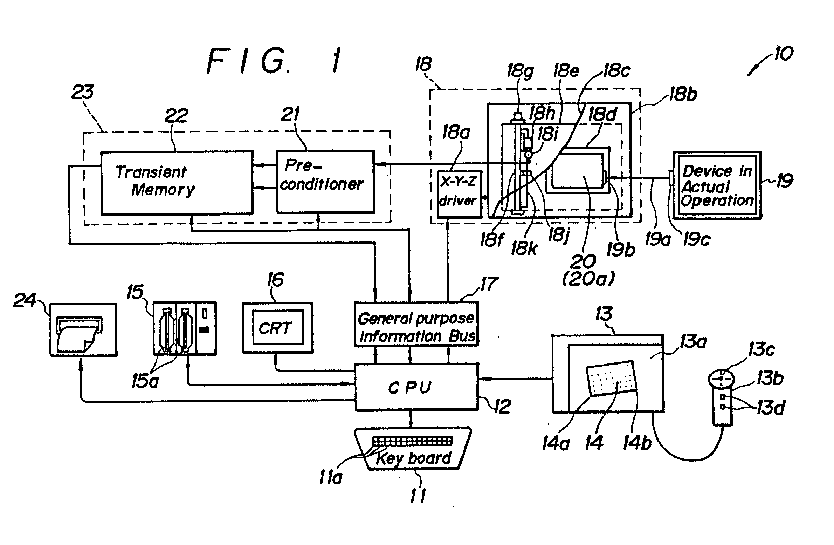

A preferred embodiment of a printed circuit board function testing system of this invention is shown in Fig. 1. In said system 10, a keyboard 11 with a plurality of keys 11a is connected to a CPU (Central Processing Unit) 12, and measuring conditions, setting and operating commands entered through said keyboard 11a. Coordinate signal detecting means 13, which comprises a coordinate board 13a of matrix-sensor and cursor 13b, is connected to said CPU 12. A bear-board 14 with the test points indicated or a test point instruction sheet is set in advance in position on said coordinate board 13a. A plurality of the test points on the bear-board is plotted by the cursor 13b to determine coordinates and sequence number, which are then stored in a magnetic hard disk or a floppy disk 15 in said CPU 12. Said cursor 13b has a transparent plate with an aim point 13c at its center and coils surrounding it. A switch 13d is turned on to release magnetic beam along the center axis of the aim point 13c when it is correctly aligned with a test point, through which the beam hits a point on the bear-board 14, where the coordinates of the test point are determined. The correct X-Y coordinates are automatically calculated and stored together with the plotting sequence numbers by said CPU 12 when two basic points of the bear-board 14, X-Y zero point at the left bottom corner 14a and the other point at the right bottom corner of the bear-board 14, are initially defined, so that positioning alignment of the bear-board 14 is not much critical. The coordinates stored by said CPU 12 can be transferred to a floppy disk or monitored on CRT 16.

The coordinate signal stored by said CPU 12 is fed to a waveform detecting means 18 which is connected to said CPU 12 through extension bus unit 17. The wave for detecting means is driven successively, test point after test point, by commanding input from the CPU by entry through keys 11a. Said waveform detecting means comprises X-Y-Z drivers 18a, and a X-Y-Z table 18b. A normally functioning PC board (base PC board) 20 is set in a positioning frame 18d in a top plate 18c of the X-Y-Z table 18b, and is connected to an active device in operation 19.

Said X-Y-Z table 18b in the shape of a housing has at its bottom guide plates 18e, on which an axis beam 18f is arranged in orientation of Y axis and is driven along X axis by X axis driving motor 18g. A sliding member driven along said axis beam 18f by Y axis driving motor 18h mounts a probe 18i which is allowed to move vertically (in Z axis direction). Said probe 18i is raised through linkage mechanism 18k by driving means like a solenoid or a driving motor 18j, thus three dimensional tracking mechanism is formed.

Said base PC board is moved from the normally functioning device 19, is placed on the X-Y-Z table 18b and is connected with said device 19 by cable 19a with connectors 19b and 19c at its both ends.

The base board 10 is put into normal operation by said device 19 while the X-Y-Z drivers 18a are activated by output signal of coordinates from the CPU commanded through the keyboard and the probe is guided to a coordinate point corresponding to the test point indicated in the bear-board by the X and Y driving motors 18g and 18h, and the probe is then raised by the Y axis driving motor 18j. The probe keeps tracking the test points of the PC board according to the indications in the bear-board 14 until the normally functioning analogue signal is obtained at all the predetermined test points.

The aforementioned mechanical structure to drive the probe 18i by the coordinate signal on the X-Y-Z table 18i is well known art, and its specific mechanism is not limited to the aforementioned embodiment.

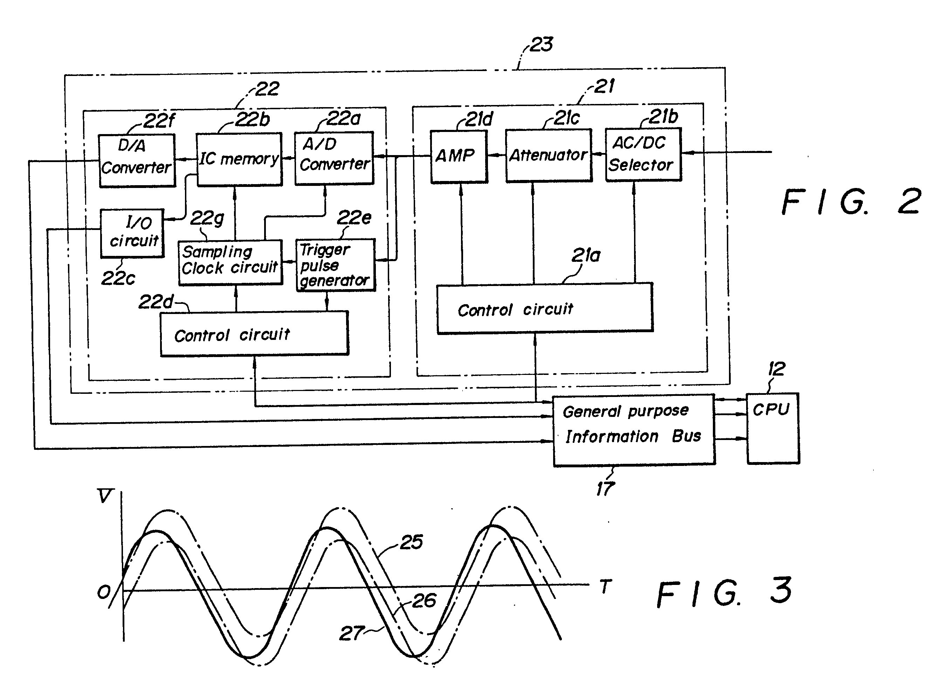

Said waveform pick-up means is connected to waveform converting and memorizing means 23 which comprises a preconditioner 21 and a transient memory 22, which is a brand name of a device manufactured by Kawasaki Electronica and which is, as is used in this description and in the appended claim, a generally called digital memory. Said pre-conditioner 21 is for processing input analogue signal so as for the transient memory 22 preferable to process before CPU processing. The pre-conditioner 21 and the transient memory 22 can be constructed in one unit. Said pre-conditioner 21 comprises an AC/DC selector 21b, an attenuator 21c, and an amplifier 21d, all of which are connected in the order described, which is shown in Fig. 2 and connected to the CPU 12 through a control circuit 21a, and receive waveform processing instruction signal by operation of the keys 11a. Analogue signal received by said waveform detecting means 18 goes through the waveform converting and memorizing means to CRT 16 to be first displayed, so that AC/DC selection, adjustment of the attenuator 21c for voltage level and compensation of offset level by the amplifier 21d are made by observing the display.

The processed analogue signal delivered from said amplifier 21d is fed to an A/D (Analogue to Digital) converter of the transient memory 22, and at the same time is sent through a branch line to a trigger pulse generator 22e. Said trigger pulse generator 22e is connected with a sampling clock circuit 22g, which is linked with both said A/D converter 22a and IC memory are connected each other. Meanwhile, said sampling clock circuit 22g and the trigger pulse generator 22e are connected through a control circuit 22d to CPU 12. When analogue signal is fed to said A/D converter 22a, condition commanding signal with coordinate address numbers assigned is delivered to the trigger generator 22e from CPU by commanding through the keys 11a. The instructions from the trigger generator 22e regarding triggering position and timing for said analogue waveform are given to the A/D converter 22a by way of the sampling clock circuit. The triggering instructions include trigger level, triggering time, and selection of triggering slope, rising slope (+) or falling slope (-). The analogue waveform is digitized from the triggered point and the digitized signal is stored by IC memory 22b. Sampling time set for the A/D converter 22a is entered through the keys 11a to CPU, and is executed through said sampling clock circuit 22g to instruct said A/D converter 22a. The sampling time is a duration of time for digital memory, and the sampling time of this embodiment is a range of from 50 nsec. through 50 sec., duration adjustable within the range. The memory is started from the time of trigger pulse generated by the trigger pulse generator 22e for a period of time set in advance, and the digital signal is stored in IC memory 22b. Both the A/D converter 22a and the IC memory 22b are synchronized with the same sampling clock circuit 22g for correctly timed memory.

Said IC memory 22b works as a buffer to store said digitized signal, and it transfers its memory contents to RAM 1 of CPU 12 through the extension bus unit 17 when predetermined amount of memory is filled; the memory is said RAM 1 is also transferred if necessary to a magnetic hard disk or a floppy disk 15a.

A D/A (Digital to Analogue) converter 22f is connected to the outlet of said IC memory 22b. The base data in the form of analogue waveform converted by said D/A converter 22f is delivered through CPU to CRT 16 for monitor display. An operator visually refers to the monitored display to enter through keys 11a condition of command signals for said waveform converting and memorizing means 23. The condition of command is AC/DC selection, voltage level adjustment, offset compensation, trigger starting timing, and sampling time, which are selectively set by the operator.

When the base data in the RAM 1 of CPU 12 is read out to be entered to a comparator in the CPU, limits of a quality acceptance level range, extent of which depend on the function represented at the test point of the base PC board, are given by command through keys 11a. The upper and lower limits forming the level range of said PC board are written into the magnetic hard disk as the test base data. The test base data can be stored in a floppy disk, and can be displayed on CRT 16 in analogue waveform through the D/A converter connected to the comparator.

In aforementioned description of the elements of this invention, accompanied description of procedures of measurement, recording and display are for a single test point. N times of the procedures, therefore, have to be repeated to measure and record n pieces of the test points according to the sequenced address numbers of the coordinate signal.

Composing for detection, treatment of the detected data, and its display of performance function of a subject PC board 20a are described below:

The base PC board 20 is removed and in its place the subject PC board 20a is positioned to be connected by the cable 19a with the active device 19.

The test base data is transferred to the RAM 1 of CPU from the magnetic hard disk or a floppy disk, and then an address number of coded coordinate signal for a test point (usually the first test point) is entered through keys 11a. The probe 18i is driven to the corresponding test point indicated by said address number by the keyed-in command, and analogue waveform is obtained in the same manner as the case of the base data. The analogue signal from the waveform detecting means 18 goes through the waveform converting and memorizing means 23 and is transformed into digital signal, which is supplied to RAM 2 of the CPU 12 for storage as a subject data.

The RAM 1 and the RAM 2 are connected to the comparator of said CPU 12, and the subject data is compared with the test base data in the comparator. The results of the comparison are printed out by a printer 24 in the character and the real number. Visual comparison between both the data is also possible by the display on CRT 16, which is connected to the comparator by way of the D/A converter. An example of the visual comparison is shown in Fig. 3, in which both the base data and the subject data are in sine wave. In Fig. 3, Y axis stands for voltage level and X for time, the respective dotted lines 25 and 26 are the upper and lower limits added to the base data, and the solid line 27 is the subject data. In case of this example, the subject PC board 20a is rejected as its waveform is not within the quality acceptance range.

The preferred embodiment of this invention is illustrated in Flowcharts 4 and 5 in which:

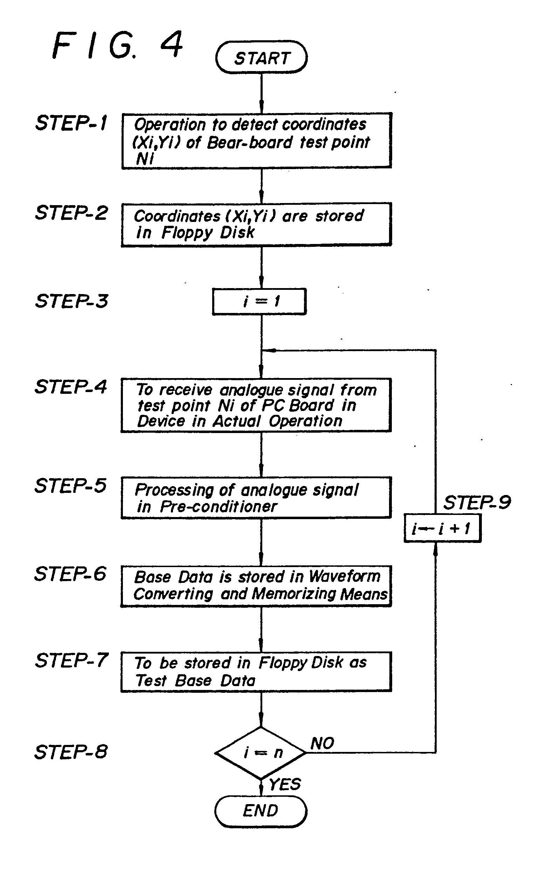

(1) Step 1 of Fig. 4: The bear-board 14 is positioned on the coordinate plate 13a of said digitizer 13. Initially the cardinal points of X-Y coordinates at both the lower end corners of the bear-board 14 are defined by locating the cursor 13b on them and pressing the switch No. 1, and then the coordinates (Xi, Yi) of each test point (i=1, 2, 3,...n) are determined pressing the switch No. 2 at each point.

Step 2 of Fig. 4: The coordinates are coded in the sequential order of the address number and stored in the magnetic hard disk of the CPU or in the floppy disk. (2) Step 3 of Fig. 4: Then the base pC board 20 is placed in position on the X-Y-Z table 18b of the waveform detecting means 18, and is connected to the device 19 in operation for actual functioning. And then the commanding signal of the first address number of the coded coordinates from the floppy disk 15a is fed to the waveform detecting means 18 through the CPU 12 to move the probe 18i for contacting with the test point N1.

Step 4 of Fig. 4: Then analogue signal is obtained from the test point N1 by the contact of the probe 18i.

Step 5 of Fig. 4: The signal is sent to the transient memory 22 through the preconditioner 21, and is transformed into digital signal which is branched and led to the D/A converter 22f for display monitoring on CRT 16. As information on the shape and characteristics of the waveform is provided by the display, selection of AC/DC in the preconditioner 21 and offset level compensation are carried out by command through keys 11a.

Step 6 of Fig. 4: A part of the digital signal in the transient memory 22 is temporarily stored in the IC memory 22 by the triggering and sampling time instructions commanded through the keys 11a.

Step 7 of Fig. 4: The processed and stored signal at the step 6 is then transferred to the RAM 1 of CPU 12 for storage as the base data, and then the quality acceptance level range having upper and lower limits is added to it to be made into a test base data and is stored in the magnetic hard disk or a floppy disk 15.

(3) Step 8 of Fig. 4: When all the procedures as described above are finished for the test point N1, the same steps from 4 through 7 are taken for the second test point N2, and go on to repeat the same procedures for all the remaining test points from N3 to Nn.

Step 9 of Fig. 4: If all the test points are not measured, "NO" warning appears on the CRT display demanding to resume from the step 4.

When all the test points have been checked, "YES" display comes on CRT, and model number of the base PC board, its manufacturing number, coded address numbers of test points Ni, test base data (upper and lower level limits), and test condition settings (voltage level of analogue waveform AC/DC selector position, and sampling time) are automatically written in the floppy disk.

(4) Measuring operation of the subject PC board 20a is described below:

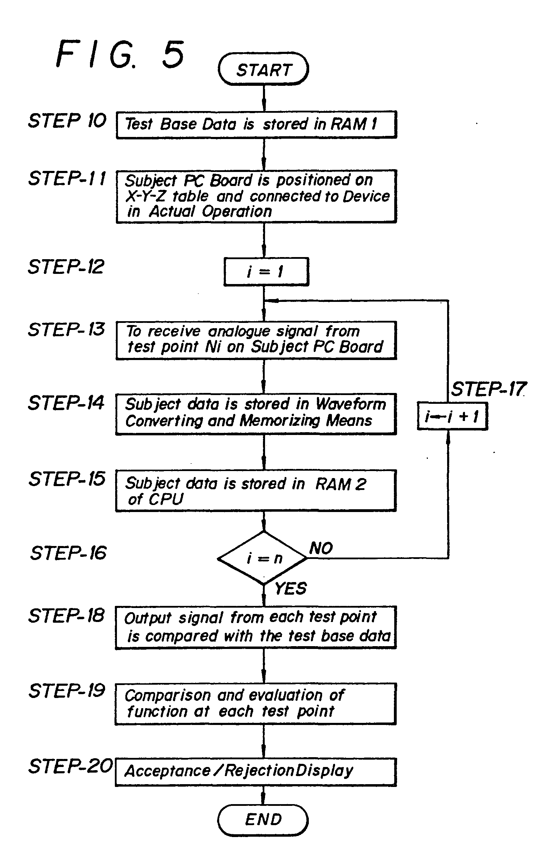

Step 10 of Fig. 5: The test base data is read out of the floppy disk and is moved to the RAM 1.

Step 11 of Fig. 5: Then the subject PC board is positioned on the X-Y-Z table 18b and connected to the device 19 in operation for actual functioning.

Step 12 of Fig. 5: Then command is keyed in through the keys IIa so that instructions from the CPU move the probe to the coordinate point of the test point N1, which is the identical location with the first test point of said subject PC board, and the probe is contacted with the test point.

Step 13 of Fig. 5: At the same time, the preconditioner 21 and the transient memory 22 receive from the CPU the same instructions as those applied for the base PC board. Then the waveform detecting means 18 obtain analogue signal at the first test point.

Step 14 of Fig. 5: The analogue signal obtained goes through the preconditioner 21 to the transient memory 22, and then to the IC memory for storage as a digital subject data.

Step 15 of Fig. 5: The subject data is then coded and stored in the RAM 2 of the CPU 12.

Steps 16, 17 of Fig. 5: When the test operation at the test point N1 of said subject PC board is finished, the same test procedures are taken for the next test point N2, then the same procedures are repeated for all the remaining test points Ni (i=3, 4, 5,...n).

Step 18 of Fig. 5: The test base data and the subject data are read out of the RAM 1 and RAM 2 respectively by the commanding operation of the keys 11a entering the code number of the coordinate signal, and are applied to the comparator of the CPU. Then the subject data of a test point is checked in the comparator if it is within the range of the test base data of the corresponding test point.

Step 19 of Fig. 5: Then the quality acceptance of the subject PC board is decided by the comparison results.

Step 20 of Fig. 5: The test results of acceptance or rejection for the subject PC board are printed out by the printer 24 connected to the comparator.

The printout indicates type of the subject PC board, PC board number, coded test point number, upper and lower limits of the test base data range at each test point, data in real number of the subject PC board at each test point, and judgement of acceptance or rejection in character. Analogue waveform of any test point marked "Rejection" can be displayed on CRT 16 together with the analogue test base data. This visual observation of the defected point helps to give specific comments when sending back the PC board for repair or reworking.

The CRT display of the waveform comparison can also be utilized for immediate correction or adjustment by adjusting potentiometers on the PC board.

**Claims**

1. A printed circuit board function testing system having CPU provided with data display means for signals obtained by keybord operation to set and command measuring conditions and to process, comprising:

coordinate signal detecting means (13) connected with said CPU (12), for determining X-Y coordinates and address numbers of a plurality of defined test points in advance in a bearboard (14) of a PC board;

waveform detecting means (18) connected with said CPU (12) to receive from it said coordinate signal, being equipped with tracking mechanism (18k, 18j) to drive a probe (18i) to X-Y coordinate point corresponding to said test point and to raise said probe (18i) at said coordinate point to contact said test point of a base PC board (20) and a subject PC board (20a), said base PC board and said subject PC board being placed in position above said mechanism, said probe when raised contacting said test point, and analogue signal being received when said probe makes contact with said test point;

waveform converting and memorizing means (23) connected with said waveform detecting means (18), processing and converting into digital said analogue signal commanded by said CPU (12) for facilitating processing and understanding in CPU, and temporarily memorizing the digital signal;

displaying by said display means (16) evaluation results of performance at each test point after comparison by a comparator in said CPU (12) between said base data and said subject data which are respectively stored in said CPU (12) with which said waveform converting and memorizing means (23) is connected.

2. Testing system according to claim 1, wherein said coordinate signal detecting means (13) comprises a coordinate plate (13a) of matrixsensor and a cursor (13b) which releases magnetic beam along the perpendicular axis of its transparent round plate when a switch (13d) is pressed.

3. Testing system according to claim 1, wherein a test point indicator of actual size comprising a test point indication sheet is placed on a coordinate plate (13a) of said coordinate signal detecting means (13).

4. Testing system according to claim 1, wherein composing means is said tracking mechanism with the probe (18i) of said waveform pick-up means (18), said probe (18i) contacting predetermined test points of back surface of the PC board in operation, being connected with the CPU (12) so as to receive coordinate commanding output signal through X-Y-Z drivers (18a), Y-axis oriented axis beam being driven by X-axis driving motor (18g), sliding member on said axis beam (18f) being driven by Y-axis driving motor (18h) along Y-axis direction, said probe (18i) mounted on said member being driven vertically along Z-axis by linkage means (18k) and driving means such as solenoid or motor (18j).

5. Testing system according to claim 1, wherein said waveform converting and memorizing means (23) comprises a preconditioner (21) and a transient memory (22) both mutually linked.

6. Testing system according to claim 1, wherein said preconditioner (21) includes an attenuator (21c) and an amplifier (21d) for voltage level adjustment, and an AC/DC selector (21b) for selection of AC or DC or said analogue waveform signal, said adjustment and selection being made by condition commanding signal from said CPU (12) selectively commanded at said keyboard (11).

7. Testing system according to claim 5, wherein said transient memory (22) includes an A/D converter (22f), an IC memory (22b), a trigger pulse generator (22e), and a sampling clock circuit (22g), said A/D converter (22f) being for converting analogue signal to digital signal, said IC memory (22b) storing temporarily digital signal according to instruction on starting time and sampling time (duration of measuring time) sent from said trigger generator (22e) and said sampling clock circuit (22g), said starting time and said sampling time being selectively set at said keyboard (11).

8. Testing system according to claim 5 and 7, wherein said IC memory (22b) is connected at its outlet with a D/A converter (22f) for display of its output on CRT (16).

9. Testing system according to claim 7, wherein said IC memory (22b) is connected to a magnetic hard disk and/or a floppy disk (15a) in the CPU (12).

10. Testing system according to claim 1, wherein RAM 1 and RAM 2, provided in said CPU (12) for storing the base data and the subject data delivered from the IC memory (22b) connected through a I/O circuit (22c) and an extension bus (17) to said RAM 1 and said RAM 2, are connected to a comparator for comparing both the data stored in said RAMs.

11. Testing system according to claim 10, wherein said printer (24) is connected to the comparator in said CPU (12).

12. Testing system according to claim 10, wherein said comparator is connected through the D/A converter (22f) to the CRT (16) of said display means.

**Patentansprüche**

1. Vorrichtung zum Funktionstest gedruckter Schaltungen mit einer Zentralverarbeitungseinheit (CPU), die versehen ist mit einer Datenanzeigeeinrichtung für durch eine Tastaturbetätigung erhaltene Signale, um Meßbedingungen einzustellen, zu steuern und zu verarbeiten, gekennzeichnet durch

eine mit der CPU (12) verbundene Koordinatensignal-Erfassungseinrichtung (13) zur Vorabbestimmung der X-Y-Koordinaten und der Adresszahlen einer Vielzahl definierter Testpunkte in einer Trägerplatte (14) einer gedruckten Schaltungsplatte,

eine mit der CPU (12) verbundene Wellenformerfassungseinrichtung (18), die das Koordinatensignal von der CPU (12) empfängt und mit einem Verfahrmechanismus (18k, 18j) versehen ist, um einen Prüfkopf (18i) zu dem dem Testpunkt entsprechenden X-Y-Koordinatenpunkt anzutreiben und den Prüfkopf (18i) an diesem Koordinatenpunkt anzuheben, so daß er den Testpunkt einer Basisschaltungsplatte (20) und einer Prüfschaltungsplatte (20a) berührt, wobei die Basisschaltungsplatte und die Prüfschaltungsplatte über dem Verfahrmechanismus angeordnet sind und der Prüfkopf im angehobenen Zustand den Testpunkt berührt, so daß ein Analogsignal empfangen wird, wenn der Prüfkopf in Berührung mit dem Testpunkt kommt,

eine mit der Wellenformerfassungseinrichtung (18) verbundene Wellenformumwandlungs- und -speichereinrichtung (23), die das durch die CPU (12) gesteuerte Analogsignal verarbeitet und in ein Digitalsignal umwandelt, um die Verarbeitung und das Verständnis in der CPU (12) zu erleichtern, und die das Digitalsignal vorübergehend speichert, wobei

die Auswertergebnisse der Arbeit an jedem Testpunkt durch die Anzeigeeinrichtung (16) anzeigbar sind, nachdem in einem Vergleicher in der CPU (12) ein Vergleich zwischen den Basisdaten und den prüfdaten erfolgte, die jeweils in der mit der Wellenformumwandlungs- und -speichereinrichtung (23) verbundenen CPU (12) gespeichert sind.

2. Testvorrichtung nach Anspruch 1, dadurch gekennzeichnet, daß die Koordinatensignal-Erfassungseinrichtung (13) eine Koordinatenplatte (13a) eines Matrixsensors und einen Cursor (13b) aufweist, der beim Drücken eines Schalters (13d) einen Magnetstrahl entlang der senkrechten Achse seiner transparenten runden Platte freigibt.

3. Testvorrichtung nach Anspruch 1, dadurch gekennzeichnet, daß auf einer Koordinatenplatte (13a) der Koordinatensignal-Erfassungseinrichtung (13) ein Testpunktanzeiger von natürlicher Größe angeordnet ist, der wenigstens ein Testpunktanzeigeblatt aufweist.

4. Testvorrichtung nach Anspruch 1, dadurch gekennzeichnet, daß die Setzeinrichtung bzw. Composereinrichtung der Verfahrmechanismus mit dem Prüfkopf (18i) der Wellenformerfassungs- bzw. -aufnahmeeinrichtung (18) ist, wobei der Prüfkopf (18i), der vorbestimmte Testpunkte der Rückseite der in Betrieb befindlichen Schaltungsplatte berührt, an die CPU (12) angeschlossen ist, um das Koordinatensteuerausgangssignal über X-Y-Z-Antriebe (18a), einen durch einen X-Achsenantriebsmotor (18g) angetriebenen, in Richtung zur Y-Achse ausgerichteten Achsenstrahl und ein auf diesem Achsenstrahl (18f) befindliches, durch einen Y-Achsenantriebsmotor (18h) entlang der Y-Achse angetriebenes Gleitstück zu empfangen, und wobei der am Gleitstück gehaltere Prüfkopf (18i) durch eine Lenkereinrichtung (18k) sowie eine Antriebseinrichtung, beispielsweise eine Magnetspule oder ein Motor (18j), vertikal entlang der Z-Achse antreibbar ist.

5. Testvorrichtung nach Anspruch 1, dadurch gekennzeichnet, daß die Wellenformumwandlungs- und -speichereinrichtung (23) einen Vorkonditionierer (21) sowie einen Zwischenspeicher (22) aufweist, die miteinander verbunden sind.

6. Testvorrichtung nach Anspruch 1, dadurch gekennzeichnet, daß der Vorkonditionierer (21) zur Spannungsniveaueinstellung ein Dämpfungsglied (21c) sowie einen Verstärker (21d) sowie zur Auswahl von Wechselstrom oder Gleichstrom oder des analogen Wellenformsignals einen Wechselstrom/Gleichstrom-Wähler (21b) aufweist, wobei das Einstellen und Auswählen mittels des Steuersignals von der CPU (12) erfolgt, das wahlweise an der Tastatur (11) eingegeben wird.

7. Testvorrichtung nach Anspruch 5, dadurch gekennzeichnet, daß der Zwischenspeicher (22) einen Analag/Digitalkonverter (22f), eine integrierte Speicherschaltung (22b), einen Triggerimpulsgenerator (22e) und eine Probenzeitschaltung (22g) aufweist, wobei der Analog/Digitalkonverter (22f) das Analogsignal in ein Digitalsignal umwandelt und die integrierte Speicherschaltung (22b) das Digitalsignal gemäß der vom Triggerimpulsgenerator (22e) und von der Probenzeitschaltung (22g) vorgegebenen Startzeit und probenzeit (Dauer der Meßzeit) vorübergehend speichert und wobei die Startzeit sowie die Probenzeit wahlweise an der Tastatur (11) einstellbar sind.

8. Testvorrichtung nach Anspruch 5 und 7, dadurch gekennzeichnet, daß die integrierte Speicherschaltung (22b) zur Anzeige ihres Ausgangssignals auf einem Bildschirmterminal (16) an ihrem Ausgang mit einem Digital/Analogkonverter (22f) verbunden ist.

9. Testvorrichtung nach Anspruch 7, dadurch gekennzeichnet, daß die integrierte Speicherschaltung (22b) an eine Magnethartdiskette und/oder eine Floppy-Disk (15a) in der CPU (12) angeschlossen ist.

10. Testvorrichtung nach Anspruch 1, dadurch gekennzeichnet, daß in der CPU (12) ein RAM-1-Speicher und ein RAM-2-Speicher vorgesehen sind, um die Basisdaten und die Prüfdaten zu speichern, die von der integrierten Speicherschaltung (22b) über eine Eingabe/Ausgabeschaltung (22c) und eine Verlängerungsbusleitung (17) dem RAM-l-Speicher und dem RAM-2-Speicher zugeleitet werden, wobei die beiden Speicher an einen Vergleicher angeschlossen sind, um die in den RAM-Speichern gespeicherten beiden Daten zu vergleichen.

11. Testvorrichtung nach Anspruch 10, dadurch gekennzeichnet, daß der Drucker (24) an den Vergleicher in der CPU (12) angeschlossen ist.

12. Testvorrichtung nach Anspruch 10, dadurch gekennzeichnet, daß der Vergleicher über den Digital/Analogkonverter (22f) an das Bildschirmterminal (16) der Anzeigeeinrichtung angeschlossen ist.

## Revendications

1. Système pour tester les fonctions d'une carte de circuits imprimés comportant une unité centrale de traitement CPU pourvue d'un moyen de visualisation de données pour des signaux obtenus par fonctionnement d'un clavier pour établir et commander des conditions de mesure et pour exécuter un traitement, comprenant:
   un moyen de détection de signaux de coordonnées (13) connecté à l'unité CPU (12), pour déterminer les coordonnées X-Y et les numéros d'adresse d'un ensemble de points de test définis d'avance dans la carte de support (14) d'une carte de circuits imprimés PC; ·
   un moyen de détection de forme d'onde (18) connecté à l'unité CPU (12) pour recevoir de celle-ci le signal de coordonnées, muni d'un mécanisme de localisation (18k, 18j) afin d'entraîner une sonde (18i) jusqu'à un point de coordonnées X-Y correspondant au point de test et de soulever la sonde (18i) au point de coordonnées pour mettre en contact le point de test d'une carte de PC de base (20) et une carte de PC examinée (20a), la carte de PC de base (20) et la carte de PC examinée étant placées à une position se trouvant au-dessus du mécanisme, la sonde en position soulevée étant en contact avec le point de test, et un signal analogique étant reçu quand la sonde établit un contact avec le point de test;
   un moyen de conversion et de mémorisation de forme d'onde (23) connecté au moyen de détection de forme d'onde (18), traitant et convertissant en signal numérique le signal analogique sous la commande de l'unité CPU (12) pour faciliter le traitement et l'interprétation dans l'unité CPU, et mémorisant temporairement le signal numérique;
   le moyen de visualisation (16) visualisant les résultats d'évaluation des performances à chaque point de test après comparaison par un comparateur se trouvant dans l'unité CPU (12) entre les données de base et les données examinées qui sont respectivement mémorisées dans l'unité CPU (12) à laquelle est connecté le moyen de conversion et de mémorisation de forme d'onde (23).

2. Système de test selon la revendication 1, dans lequel le moyen de détection de signaux de coordonnées (13) comprend une plaque de coordonnées (13a) d'un détecteur matriciel et un curseur (13b) qui libère un faisceau magnétique le long de l'axe perpendiculaire de sa plaque ronde transparente quand un commutateur (13d) est enfoncé.

3. Système de test selon la revendication 1, dans lequel un indicateur de point de test de grandeur réel comprenant une feuille d'indication de point de test est placé sur une plaque de coordonnées (13a) du moyen de détection de signaux de coordonnées (13).

4. Système de test selon la revendication 1, dans lequel le moyen de composition est le mécanisme de localisation avec la sonde (18i) du moyen de détection de forme d'onde (18), la sonde (18i) étant en contact avec des points de test prédéterminés de la surface arrière de la carte de PC en fonctionnement, étant connectée à l'unité CPU (12) de manière à recevoir le signal de sortie de commande de coordonnées par des éléments d'entraînement X-Y-Z (18a), un faisceau dont l'axe est orienté suivant l'axe Y étant entraîné par un moteur d'entraînement dans la direction d'axe X (18g), un élément de coulissement suivant l'axe du faisceau (18f) étant entraîné par un moteur d'entraînement dans la direction Y (18h) le long de la direction d'axe Y, la sonde (18i) montée sur l'élément étant entraînée verticalement le long d'un axe Z par un moyen de couplage (18k) et un moyen d'entraînement tel qu'un solénoïde ou un moteur (18j).

5. Système de test selon la revendication 1, dans lequel le moyen de conversion et de mémorisation de forme d'onde (23) comprend un préconditionneur (21) et une mémoire de transition (22) mutuellement couplés.

6. Système de test selon la revendication 1, dans lequel le préconditionneur (21) comprend un atténuateur (21c) et un amplificateur (21d) pour un réglage de niveau de tension, et un sélecteur de courant alternatif/continu (21b) pour la sélection d'un courant alternatif ou continu ou le signal de forme d'onde analogique, le réglage et la sélection étant faits au moyen d'un signal de commande de condition provenant de l'unité CPU (12) commandé sélectivement par le clavier (11).

7. Système de test selon la revendication 5, dans lequel la mémoire de transition (22) comprend un convertisseur analogique-numérique A/N(22f), une mémoire de circuits intégrés CI (22b), un générateur d'impulsions de déclenchement (22e), et un circuit d'horloge d'échantillonnage (22g), le convertisseur A/N (22f) servant à convertir un signal analogique en signal numérique, la mémoire de CI (22b) mémorisant temporairement un signal numérique selon une instruction sur le temps de début et le temps d'échantillonnage (durée du temps de mesure) envoyée par le générateur d'impulsions de déclenchement (22e) et le circuit d'horloge d'échantillonnage (22g), le temps de début et le temps d'échantillonnage étant établis sélectivement par le clavier (11).

8. Système de test selon l'une quelconque des revendications 5 et 7, dans lequel la mémoire de CI (22b) est connectée par sa sortie à un convertisseur numérique analogique N/A (22f) pour visualiser son signal de sortie sur un tube à rayons cathodiques TRC (16).

9. Système de test selon la revendication 7, dans lequel la mémoire de CI (22b) est connectée à un disque dur magnétique et/ou un disque souple (15a) se trouvant dans l'unité CPU (12).

10. Système de test selon la revendication 1, dans lequel une mémoire vive RAM 1 et une mémoire vive RAM 2, prévues dans l'unité CPU (12) servant à mémoriser les données de base et les données examinées délivrées par la mémoire de CI (22b) connectée par un circuit d'entrée/sortie (22c) et un bus d'extension (17) à la mémoire RAM 1 et à la mémoire RAM 2, sont connectées à un comparateur pour comparer les données mémorisées dans les deux mémoires RAM.

11. Système de test selon la revendication 10, dans lequel une imprimante (24) est connectée au comparateur dans l'unité CPU (12).

12. Système de test selon la revendication 10, dans lequel le comparateur est connecté par le convertisseur N/A (22f) au tube TRC (16) du moyen de visualisation.

F I G. 1

EP 0 202 447 B1

FIG. 2

FIG. 3

EP 0 202 447 B1

# F I G. 4

START

STEP-1 | Operation to detect coordinates (Xi,Yi) of Bear-board test point Ni

STEP-2 | Coordinates (Xi,Yi) are stored in Floppy Disk

STEP-3 | i = 1

STEP-4 | To receive analogue signal from test point Ni of PC Board in Device in Actual Operation

STEP-5 | Processing of analogue signal in Pre-conditioner

STEP-9 | i ← i + 1

STEP-6 | Base Data is stored in Waveform Converting and Memorizing Means

STEP-7 | To be stored in Floppy Disk as Test Base Data

STEP-8 | i = n — NO

YES

END

3

# F I G. 5

```
                        ┌─────────────┐
                        │    START    │
                        └──────┬──────┘
                               │
STEP 10      ┌─────────────────────────────────────┐
             │ Test Base Data is  stored in RAM 1   │
             └─────────────────┬───────────────────┘
                               │
STEP-11      ┌─────────────────────────────────────┐
             │ Subject PC Board is positioned on    │
             │ X-Y-Z table and connected to Device  │
             │ in  Actual Operation                 │
             └─────────────────┬───────────────────┘
                               │
STEP-12             ┌──────────────────┐
                    │      i = 1        │
                    └────────┬─────────┘
                             │
STEP-13      ┌─────────────────────────────────────┐
             │ To receive analogue signal from     │
             │ test point Ni on Subject PC Board   │
             └─────────────────┬───────────────────┘
                               │                          STEP-17
STEP-14      ┌─────────────────────────────────────┐    ┌─────────┐
             │ Subject data is stored in Waveform   │    │ i←i + 1 │
             │ Converting and Memorizing Means      │    └─────────┘
             └─────────────────┬───────────────────┘
                               │
STEP-15      ┌─────────────────────────────────────┐
             │ Subject data is stored in  RAM 2    │
             │ of CPU                               │
             └─────────────────┬───────────────────┘
                               │
STEP-16                  ◇ i = n ◇  ──NO──┐
                          │YES
                          │
STEP-18      ┌─────────────────────────────────────┐
             │ Output signal from each test point   │
             │ is compared with the test base data  │
             └─────────────────┬───────────────────┘
                               │
STEP-19      ┌─────────────────────────────────────┐
             │ Comparison and evaluation of         │
             │ function at  each test point         │
             └─────────────────┬───────────────────┘
                               │
STEP-20      ┌─────────────────────────────────────┐
             │ Acceptance / Rejection Display       │
             └─────────────────┬───────────────────┘
                               │
                        ┌─────────────┐
                        │     END     │
                        └─────────────┘
```